# EUROPEAN PATENT APPLICATION

(11) **EP 4 763 514 A1**
(43) Date of publication of application: **24.06.2026**
(21) Application number: 24930579.8
(22) Date of filing: 24.12.2024
(51) Int. Cl.: B32B 27/02, B32B 27/12

(54) **FIBER COMPOSITE PANEL AND TERMINAL DEVICE**

(30) Priority: 21.03.2024 CN 202410332397
(71) Applicant: HUAWEI TECHNOLOGIES CO., LTD., Shenzhen 518129 (CN)
(72) Inventor: LIN, Hongfan, Shenzhen, Guangdong 518129 (CN); WANG, Zheng, Shenzhen, Guangdong 518129 (CN); WANG, Huan, Shenzhen, Guangdong 518129 (CN); YUAN, Hang, Shenzhen, Guangdong 518129 (CN); XI, Jiaojiao, Shenzhen, Guangdong 518129 (CN)
(74) Representative: Pfenning, Meinig & Partner mbB
(86) International application number: PCT/CN2024/141841
(87) International publication number: WO 2025/194923

(57) **Abstract**

This application provides a fiber composite plate and a terminal device. The fiber composite plate includes at least one fiber composite layer, each fiber composite layer includes fiber fabric and polymer resin, and the polymer resin fills pores of the fiber fabric and encapsulates the fiber fabric. The fiber fabric includes a first fiber and a second fiber that are interwoven, a tensile modulus of the first fiber is greater than or equal to 150 Gpa, and a bending modulus of the second fiber is greater than or equal to 35 Gpa. Puncture strength of the fiber composite plate is greater than 130 N. In this application, the first fiber and the second fiber are effectively combined, so that the fiber composite plate meets a structural strength requirement of a housing of an electronic product, and a thickness of the housing is expected to be reduced. In this way, the housing features lightweight, thinness, and high strength.

## Description

### CROSS-REFERENCE TO RELATED APPLICATIONS

This application claims priority to Chinese Patent Application No. 202410332397.8, filed with the China National Intellectual Property Administration on March 21, 2024 and entitled "FIBER COMPOSITE PLATE AND TERMINAL DEVICE", which is incorporated herein by reference in its entirety.

### TECHNICAL FIELD

This application relates to the field of composite materials, and specifically, to a fiber composite plate and a terminal device.

### BACKGROUND

Currently, rear housings of most consumer electronic products, such as mobile phones and tablets, are made from glass fiber composite materials, to encapsulate internal electronic components. An existing rear housing is usually made from a glass fiber. Because puncture strength of the glass fiber is low, five or six layers of glass fiber fabric with a thickness of 0.08 mm to 0.2 mm need to be laminated to improve structural strength of the rear housing and meet anti-drop performance, to protect key components such as a battery, a camera, and a substrate inside an entire device. Consequently, puncture strength of a material of the existing rear housing is low, and an overall thickness is usually large. Generally, the overall thickness of the finished rear housing is greater than 0.5 mm. This thickness cannot meet a current requirement for lighter and thinner entire devices.

### SUMMARY

This application provides a fiber composite plate and a terminal device. A high-strength housing can be obtained by using the fiber composite plate, and a thickness of the housing is expected to be reduced.

According to a first aspect, this application provides a fiber composite plate, including at least one fiber composite layer. Each fiber composite layer includes fiber fabric and polymer resin, and the polymer resin fills pores of the fiber fabric and encapsulates the fiber fabric. The fiber fabric includes a first fiber and a second fiber that are interwoven, a tensile modulus of the first fiber is greater than or equal to 150 Gpa, and a bending modulus of the second fiber is greater than or equal to 35 Gpa. Puncture strength of the fiber composite plate is greater than 130 N.

The fiber composite plate in this application includes at least one fiber composite layer, each fiber composite layer includes the fiber fabric and the polymer resin, the polymer resin fills the pores of the fiber fabric and encapsulates the fiber fabric, and the fiber composite plate is obtained through hot-pressing molding of the at least one fiber composite layer. The fiber fabric includes the first fiber and the second fiber that are interwoven, the tensile modulus of the first fiber is greater than or equal to 150 Gpa, and the first fiber with a high tensile modulus can enable the fiber composite plate to have high tensile strength, to improve the puncture strength of the fiber composite plate. The bending modulus of the second fiber is greater than or equal to 35 Gpa, and the second fiber may be used as a reinforcing fiber, so that the fiber composite plate has high bending strength, to improve rigidity of the fiber composite plate. In this application, the first fiber and the second fiber are effectively combined, so that the puncture strength of the fiber composite plate is greater than 130 N. When the fiber composite plate is used in a housing, a structural strength requirement of the housing of an electronic product is met, and a thickness of the housing may be expected to be reduced, so that the housing features lightweight, thinness, and high strength.

In an optional implementation, a percentage by mass of the first fiber in each layer of the fiber fabric is 1 wt.% to 99 wt.%, for example, 30% to 99%, for another example, 40% to 95%, for another example, 50% to 90%, for another example, 60% to 90%. A percentage by mass of the second fiber in each layer of the fiber fabric is 1 wt.% to 99 wt.%, for example, 5% to 55%, for another example, 7% to 50%, for another example, 9% to 45%, for another example, 10% to 45%, and for another example, 10% to 40%. Appropriately setting the percentage by mass of the first fiber and the percentage by mass of the second fiber in each layer of the fiber fabric can maximize functions of the first fiber and the second fiber. In other words, advantages of the first fiber and the second fiber are effectively combined, so that the final fiber composite plate has high strength and rigidity. This helps implement lightweight and thinness of the fiber composite plate.

In an optional implementation, a diameter of the first fiber is 10 µm to 18 µm, and a diameter of the second fiber is 5 µm to 15 µm. In a fiber preparation process, the first fiber and the second fiber with different fiber diameters may be obtained. The diameters of the first fiber and the second fiber are appropriately designed, so that the first fiber and the second fiber are well matched, and advantages of the first fiber and the second fiber are effectively combined. In this way, the final fiber composite plate has high strength and rigidity, thereby facilitating lightweight and thinness of the fiber composite plate.

In an optional implementation, porosity of the fiber fabric is less than or equal to 5%. Controlling the porosity of the fiber fabric formed by interweaving the first fiber and the second fiber can improve density of the fiber fabric and further improve strength and rigidity of the fiber composite plate.

In an optional implementation, the first fiber includes a poly(p-phenylene benzobisoxazole) (precision boost overdrive, PBO) fiber, and the second fiber includes one of a glass fiber and a ceramic fiber. It may be understood that first fibers in different fiber composite layers of a same fiber composite plate may be the same or different. For example, a fiber composite plate has three fiber composite layers. In a first fiber composite layer, a first fiber is a PBO fiber, and a second fiber is a glass fiber. In a second fiber composite layer, a first fiber is a PBO fiber, and a second fiber is a ceramic fiber. In a third fiber composite layer, a first fiber is a PBO fiber, and a second fiber is a glass fiber.

In an optional implementation, a percentage by mass of the polymer resin in each fiber composite layer is 30 wt.% to 50 wt.%. Content of the polymer resin in each fiber composite layer is appropriately adjusted according to an actual situation, so that a structure of each layer of fiber fabric can be more stable, which is conducive to curing and molding of the fiber composite layer and the fiber composite plate.

In an optional implementation, the polymer resin includes at least one of epoxy resin, bismaleimide resin, polycarbonate resin, or polyetheretherketone resin. It may be understood that polymer resin in different fiber composite layers of a same fiber composite plate may be the same or different.

In an optional implementation, there are two to five fiber composite layers. A quantity of fiber composite layers may be adjusted based on an actual thickness of each fiber composite layer, so that the final fiber composite plate achieves required strength and rigidity.

In an optional implementation, a thickness of the fiber composite plate is less than 0.5 mm. The fiber composite plate in this application is formed by combining the fiber fabric formed by interweaving the first fiber and the second fiber with the polymer resin, so that the thickness of the fiber composite plate can be reduced to less than 0.5 mm, and the fiber composite plate has features such as high strength and good rigidity.

For data in the foregoing possible implementations of this application, for example, data such as the tensile modulus, the thickness, the diameter, and the strength, during measurement, a value within an engineering measurement error range should be understood as falling within a range limited in this application.

According to a second aspect, this application provides a terminal device, including a housing and an electronic component disposed in the housing. At least a part of the housing is the fiber composite plate according to the first aspect.

In the terminal device in this application, the fiber composite plate may be used as at least a part of a housing of an apparatus like a mobile phone, a computer, an electronic watch, a display, a home appliance, or a vehicle. Because puncture strength of the fiber composite plate in this application is greater than 130 N, when the fiber composite plate in this application is used as the housing of the terminal device, the fiber composite plate has high strength and rigidity, so that structural strength for protecting an internal electronic component can be met while a thickness of the housing is reduced. This helps implement lightweight and thinness of the entire device.

For technical effects that can be achieved in the second aspect, refer to corresponding effect descriptions in the first aspect. Details are not described herein again.

### BRIEF DESCRIPTION OF DRAWINGS

FIG. 1 is a diagram of a structure of a fiber composite plate composite according to an embodiment of this application;
FIG. 2 is a diagram of a structure of fiber fabric according to an embodiment of this application;
FIG. 3 is a diagram of a structure of another type of fiber fabric according to an embodiment of this application; and
FIG. 4 is a diagram of a structure of another type of fiber fabric according to an embodiment of this application.

### Reference numerals:

1: fiber composite layer; 2: first fiber; and 3: second fiber.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. Terms "one", "a", "the foregoing", "the", and "the one" of singular forms used in this specification and the appended claims of this application are also intended to include plural forms like "one or more", unless otherwise specified in the context clearly.

Reference to "one embodiment", "some embodiments", or the like described in this specification means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

An electronic device like a mobile phone, a computer, an electronic watch, a display, a household appliance, or a vehicle, usually has a housing to package electronic components such as a battery, a camera, and a substrate inside the electronic device, to protect the electronic components. As a housing of an electronic device, the housing needs to have high structural strength and a small thickness, to protect a key component and meet requirements for lightweight and thinness. However, existing materials cannot meet requirements for lightweight, thinness, and high strength. Therefore, this application provides a fiber composite plate. A housing prepared by using the fiber composite plate may have a small thickness on a basis of high strength.

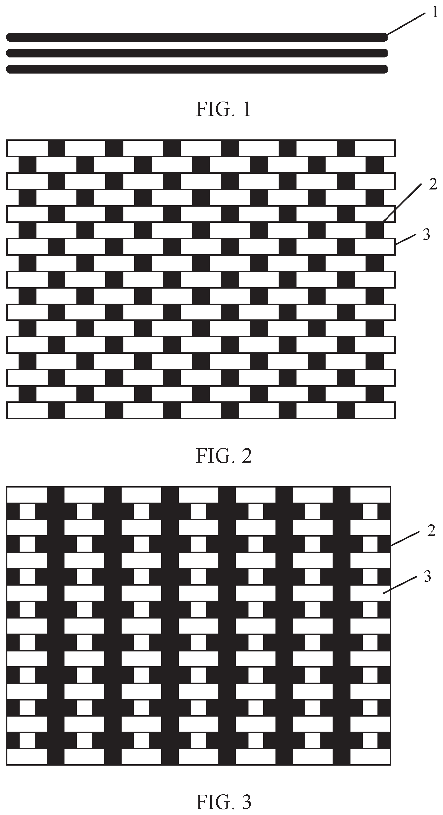

FIG. 1 is a diagram of a structure of a fiber composite plate composite. As shown in FIG. 1, the fiber composite plate includes a fiber composite layer 1. There may be one fiber composite layer 1, or may be a plurality of fiber composite layers 1, for example, two to five fiber composite layers 1. For example, a quantity of fiber composite layers 1 may be, for example, one layer, two layers, three layers, four layers, five layers, six layers, or more layers. When there are a plurality of fiber composite layers 1, the fiber composite plate is obtained by stacking and hot-pressing the plurality of fiber composite layers 1.

Each fiber composite layer 1 includes fiber fabric and polymer resin, and the polymer resin fills pores of the fiber fabric and encapsulates the fiber fabric. The fiber fabric may be used as a reinforcement, to improve lightweight and rigidity of the fiber composite plate, and help reduce a thickness of the fiber composite plate. The polymer resin is used as a matrix to fill the pores of the fiber fabric, improve structural density of the fiber fabric, and disperse loads to the entire fiber fabric, to ensure improvement of structural stability of the fiber composite plate. In addition, the polymer resin encapsulates the fiber fabric, which helps protect the fiber fabric from an external environment and force, and reduce a possibility of damage to the fiber composite plate. The fiber fabric and the polymer resin work together to achieve optimal quality and performance of fiber composite plate.

The following separately describes structural compositions of the fiber fabric and the polymer resin.

The fiber fabric in this embodiment of this application may be obtained by using a bidirectional weaving process of a first fiber 2 and a second fiber 3. FIG. 2 is a diagram of a structure of fiber fabric according to an embodiment. As shown in FIG. 2, fiber fabric in each fiber composite layer 1 includes a first fiber 2 and a second fiber 3 that are interwoven. In a first direction, only the first fiber 2 is arranged, and in a second direction, only the second fiber 3 is arranged, that is, there is an included angle between the first fiber 2 and the second fiber 3.

FIG. 3 is a diagram of a structure of fiber fabric according to another embodiment. As shown in FIG. 3, fiber fabric in each fiber composite layer 1 also includes a first fiber 2 and a second fiber 3 that are interwoven. In a first direction and a second direction, both the first fiber 2 and the second fiber 3 are arranged, that is, there is an included angle between a part of first fibers 2 and second fibers 3, and the other part of first fibers 2 and second fibers 3 are parallel.

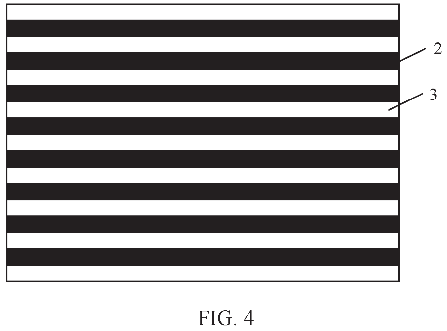

It should be noted that FIG. 4 is a diagram of a structure of fiber fabric according to another embodiment. As shown in FIG. 4, the fiber fabric may alternatively be obtained by using a unidirectional weaving process of a first fiber 2 and a second fiber 3, that is, all first fibers 2 and second fibers 3 are arranged in parallel.

In each fiber composite layer 1, a tensile modulus of the first fiber 2 is greater than or equal to 150 Gpa, that is, the first fiber 2 is used to provide high tensile strength for a fiber composite plate, to improve puncture strength of the fiber composite plate. In each fiber composite layer 1, a bending modulus of the second fiber 3 is greater than or equal to 35 Gpa, and the second fiber 3 may be used as a reinforcing fiber, to provide high bending strength for the fiber composite plate, so as to improve rigidity of the fiber composite plate, and improve flatness of the fiber composite plate. A tensile modulus of the second fiber may be less than 150 Gpa. A bending modulus of the first fiber may be less than 35 Gpa.

The fiber composite plate in this embodiment of this application is obtained by combining, with a polymer resin, the fiber fabric formed by interweaving the first fiber 2 and the second fiber 3, so that the puncture strength of the fiber composite plate is greater than 130 N. When the fiber composite plate is used in a housing, a structural strength requirement of the housing of an electronic product is met, and a thickness of the housing may be expected to be reduced, so that the housing feature lightweight, thinness, and high strength.

Refer to FIG. 2 to FIG. 4. In the fiber composite plate in this embodiment of this application, a percentage by mass of the first fiber 2 in each layer of fiber fabric is 1 wt.% to 99 wt.%. For example, the percentage by mass of the first fiber 2 in each layer of fiber fabric is 1 wt.%, 5 wt.%, 10 wt.%, 20 wt.%, 30 wt.%, 40 wt.%, 50 wt.%, 60 wt.%, 70 wt.%, 80 wt.%, 90 wt.%, 99 wt.%, or the like. Correspondingly, a percentage by mass of the second fiber 3 in each layer of fiber fabric is 99 wt.% to 1 wt.%. For example, a percentage by mass of the second fiber 3 in each layer of fiber fabric is 99 wt.%, 90 wt.%, 80 wt.%, 70 wt.%, 60 wt.%, 50 wt.%, 40 wt.%, 30 wt.%, 20 wt.%, 10 wt.%, 5 wt.%, 1 wt.%, or the like. It may be understood that the foregoing values are merely examples for description, and the foregoing values may be minimum values or maximum values. Values between any two of the foregoing values fall within the protection scope of this application. In this application, appropriately setting the percentage by mass of the first fiber 2 and the percentage by mass of the second fiber 3 in each layer of fiber fabric can maximize functions of the first fiber 2 and the second fiber 3. In other words, advantages of the first fiber 2 and the second fiber 3 are effectively combined, so that the final fiber composite plate has high strength and rigidity. This helps reduce a thickness of the fiber composite plate when a strength requirement is met, to achieve lightweight and thinness of the entire device.

The first fiber 2 and the second fiber 3 with different diameters may be prepared by using a dry-jet wet spinning process, and then the first fiber 2 and the second fiber 3 with different diameters are woven into fiber fabric by using a unidirectional or bidirectional weaving process. Specifically, a diameter of the first fiber 2 is 10 µm to 18 µm. For example, the diameter of the first fiber 2 is 10 µm, 11 µm, 12 µm, 13 µm, 14 µm, 15 µm, 16 µm, 17 µm, 18 µm, or the like. A diameter of the second fiber 3 is 5 µm to 15 µm. For example, the diameter of the second fiber 3 is 5 µm, 6 µm, 7 µm, 8 µm, 9 µm, 10 µm, 11 µm, 12 µm, 13 µm, 14 µm, 15 µm, or the like. It may be understood that the foregoing values are merely examples for description, and the foregoing values may be minimum values or maximum values. Values between any two of the foregoing values fall within the protection scope of this application. In preparation processes of the first fiber 2 and the second fiber 3, the diameter of the first fiber 2 and the diameter of the second fiber 3 in each layer of fiber composite layer 1 are appropriately designed, so that the first fiber 2 and the second fiber 3 are well matched, and advantages of the first fiber 2 and the second fiber 3 can be better combined. In this way, the final fiber composite plate has high strength and rigidity, thereby facilitating lightweight and thinness of the fiber composite plate.

Refer to FIG. 2 to FIG. 4. In embodiments of this application, porosity of the fiber fabric of each fiber composite layer 1 is less than or equal to 5%. For example, the porosity of the fiber fabric of each fiber composite layer 1 is 0%, 0.5%, 1%, 1.5%, 2%, 2.5%, 3%, 3.5%, 4%, 4.5%, or 5%. The porosity of the fiber fabric formed by interweaving the first fiber 2 and the second fiber 3 is controlled, so that the polymer resin can be filled in interweaving pores of the first fiber 2 and the second fiber 3 as much as possible. This can improve density of the fiber fabric and further improve strength and rigidity of the fiber composite plate.

Still refer to FIG. 2 to FIG. 4. In embodiments of this application, the first fiber 2 includes but is not limited to a PBO fiber, and the second fiber 3 includes but is not limited to one of a glass fiber and a ceramic fiber. It should be noted that first fibers 2 in different fiber composite layers 1 of a same fiber composite plate may be the same or different. For example, a fiber composite plate has three fiber composite layers 1. In a first fiber composite layer, a first fiber 2 is a PBO fiber, and a second fiber 3 is a glass fiber. In a second fiber composite layer, a first fiber 2 is a PBO fiber, and a second fiber 3 is a ceramic fiber. In a third fiber composite layer, a first fiber 2 is a PBO fiber, and a second fiber 3 is a glass fiber.

A percentage by mass of the polymer resin in each fiber composite layer 1 is 30 wt.% to 50 wt.%. For example, the percentage by mass of the polymer resin in each fiber composite layer 1 is 30 wt.%, 35 wt.%, 40 wt.%, 45 wt.%, 50 wt.%, or the like. Content of the polymer resin in each fiber composite layer 1 is appropriately adjusted, so that a structure of each layer of fiber fabric can be more stable, which is conducive to curing and molding of the fiber composite layer 1 and the fiber composite plate. In embodiments of this application, the percentage by mass of the first fiber 2, the percentage by mass of the second fiber 3, and the percentage by mass of the polymer resin are appropriately designed, so that the fiber composite plate has high structural strength in a case of a low thickness.

The polymer resin includes one of thermosetting resin and thermoplastic resin. The thermosetting resin includes but is not limited to at least one of epoxy resin or bismaleimide resin. The thermoplastic resin includes but is not limited to at least one of polycarbonate resin or polyetheretherketone resin. Preferably, the epoxy resin is used as the polymer resin. It should be noted that polymer resin in different fiber composite layers 1 of a same fiber composite plate may be the same or may be different. For example, a fiber composite plate has three fiber composite layers 1. Polymer resin in a first fiber composite layer is epoxy resin, polymer resin in a second fiber composite layer is bismaleimide resin, and polymer resin in a third fiber composite layer is epoxy resin.

It should be additionally noted that the fiber composite plate in this embodiment of this application may further include at least one of a flame retardant, a coupling agent, a curing agent, an antioxidant, or color powder. The flame retardant can ensure safety of an electronic product in a use process and a charging process. The coupling agent is used to enhance interface performance of a material, so that a polymer resin material is better bonded and solidified with the fiber fabric, and bonding strength between the polymer resin material and the fiber fabric is improved. When the used polymer resin is thermosetting resin, a curing agent further needs to be added. The curing agent can initiate or accelerate a curing reaction of the fiber composite layer 1, to promote formation of the fiber composite layer 1, and make the fiber composite layer 1 more solid and stable. The antioxidant can delay or inhibit oxidation and color change of the fiber composite layer 1, and prolong a service life. The color powder is used to improve appearance quality of the fiber composite plate, and meet requirements of different users on colors.

The fiber composite plate in this embodiment of this application may be obtained by stacking and hot-pressing two to five fiber composite layers 1. Refer to FIG. 1. The fiber composite plate is made of three fiber composite layers 1. A quantity of fiber composite layers 1 may be adjusted based on an actual thickness of each fiber composite layer 1, so that the final fiber composite plate achieves required strength and rigidity. It should be noted that a plurality of fiber composite layers 1 in the fiber composite plate may be the same or different, weaving processes of fiber fabric in the plurality of fiber composite layers 1 may be the same or different, and polymer resin in the plurality of fiber composite layers 1 may be the same or different. For example, a fiber composite plate has three fiber composite layers 1. In a first fiber composite layer, a first fiber 2 is a PBO fiber, a second fiber 3 is a glass fiber, fiber fabric is formed by the first fiber 2 and the second fiber 3 by using the bidirectional weaving process, and polymer resin is epoxy resin. In a second fiber composite layer, a first fiber 2 is a PBO fiber, a second fiber 3 is a ceramic fiber, fiber fabric is formed by the first fiber 2 and the second fiber 3 by using the unidirectional weaving process, and polymer resin is bismaleimide resin. In a third fiber composite layer, a first fiber 2 is a PBO fiber, a second fiber 3 is a glass fiber, fiber fabric is formed by the first fiber 2 and the second fiber 3 by using the bidirectional weaving process, and polymer resin is epoxy resin.

It should be additionally noted that a thickness of each fiber composite layer 1 is 0.05 mm to 0.20 mm. For example, the thickness of each fiber composite layer 1 may be 0.05 mm, 0.06 mm, 0.07 mm, 0.08 mm, 0.09 mm, 0.10 mm, 0.11 mm, 0.12 mm, 0.13 mm, 0.14 mm, 0.15 mm, 0.16 mm, 0.17 mm, 0.18 mm, 0.19 mm, 0.20 mm, or the like.

In this application, advantages of the first fiber 2 and the second fiber 3 are effectively combined, so that the fiber composite plate can reduce the thickness of the fiber composite plate to less than 0.5 mm while meeting a structural strength requirement of a housing of an electronic product. The housing features lightweight, thinness, and high strength.

A preparation process of the fiber composite plate in this embodiment of this application includes the following steps.

S201: Mix polymer resin with a flame retardant, a coupling agent, a curing agent, an antioxidant, and color powder to form slurry.

S202: Make same/different fiber fabric pass through a dipping tank containing the slurry, to obtain same/different single-layer fiber composite layer 1 prepreg.

S203: Stack a plurality of same/different fiber composite layer 1 prepreg layers and perform hot-pressing, to obtain a fiber composite plate, where a temperature for hot-pressing is 140°C to 160°C, and processing time is 4 to 7 min.

In this embodiment of this application, the fiber composite plate with puncture strength greater than 130 N may be prepared by combining the fiber fabric with the polymer resin. In addition, the fiber fabric is woven and formed by the first fiber 2 and the second fiber 3, which effectively combines advantages of the two fibers, and helps improve strength and rigidity of the fiber composite plate, so that the fiber composite plate has a small thickness while having high structural strength, to comply with a trend of lightweight and thinness of an entire device.

The fiber composite plate in this application is used in a housing of a terminal device, and strength and rigidity of the fiber composite plate can enable the housing to protect internal electronic components at a small thickness.

The following further describes the fiber composite plate in this application in detail with reference to specific embodiments.

A preparation process of the PBO fiber in the following embodiments is as follows: performing a polycondensation reaction on 4,6-diaminophenol dihydrochloride and benzenedicarboxylic acid to prepare PBO resin, and processing the PBO resin by using a dry-jet wet spinning process, to prepare PBO fibers with different diameters. A tensile modulus of the PBO fiber is 240 Gpa, a bending modulus is 20 Gpa, and a fiber diameter is 12 µm. A tensile modulus of the ceramic fiber is 270 Gpa, a bending modulus is 55 Gpa, and a fiber diameter is 12 µm. A tensile modulus of the glass fiber is 80 Gpa, a bending modulus is 28 Gpa, and a fiber diameter is 10 µm. In this embodiment, porosity of the fiber fabric is less than or equal to 5%. The polymer resin used in this embodiment is epoxy resin (a blend of bisphenol A epoxy resin and biphenyl epoxy resin), the flame retardant is aluminum hydroxide, the coupling agent is an aminosilane coupling agent, the curing agent is imidazole, the antioxidant is an antioxidant 1010, and the color powder is titanium dioxide. It should be noted that, in the slurry in the following embodiments, the epoxy resin accounts for 90wt.%, and the flame retardant, the coupling agent, the curing agent, the antioxidant, and the color powder account for 10 wt.% in total in a preparation process. The fiber fabric in the following embodiments is woven in the manner shown in FIG. 2.

### Embodiment 1

This embodiment provides a fiber composite plate, which is prepared by using the following method.

S301: Prepare slurry according to the foregoing method.

S302: Form, by using 60 wt.% of PBO fibers and 40 wt.% of ceramic fibers, fiber fabric by using a bidirectional weaving process, and make the fiber fabric pass through a dipping tank containing the slurry, to obtain single-layer fiber composite layer prepreg with a thickness of 0.12 mm.

S303: Stack three fiber composite layer prepreg layers and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 200 N, and a bending modulus is 36 Gpa.

### Embodiment 2

This embodiment provides a fiber composite plate, which is prepared by using the following method.

S301: Prepare slurry according to the foregoing method.

S302: Form, by using 60 wt.% of PBO fibers and 40 wt.% of glass fibers, fiber fabric by using a bidirectional weaving process, and make the fiber fabric pass through a dipping tank containing the slurry, to obtain single-layer fiber composite layer prepreg with a thickness of 0.12 mm.

S303: Stack three fiber composite layer prepreg layers and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 180 N, and a bending modulus is 29 Gpa.

### Embodiment 3

This embodiment provides a fiber composite plate, which is prepared by using the following method.

S301: Prepare slurry according to the foregoing method.

S302. Form, by using 60 wt.% of PBO fibers and 40 wt.% of glass fibers, a first type of fiber fabric by using a bidirectional weaving process, form, by using 60 wt.% of PBO fibers and 40 wt.% of ceramic fibers, a second type of fiber fabric by using the bidirectional weaving process, and make the first type of fiber fabric and the second type of fiber fabric pass through dipping tanks containing the slurry, to obtain different single-layer fiber composite layer prepreg with thickness of 0.12 mm.

S303: Stack two fiber composite layer prepreg layers containing the first type of fiber fabric and one fiber composite layer prepreg layer containing the second type of fiber fabric and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 190 N, and a bending modulus is 31 Gpa.

### Embodiment 4

This embodiment provides a fiber composite plate, which is prepared by using the following method.

S301: Prepare slurry according to the foregoing method.

S302: Form, by using 70 wt.% of PBO fibers and 30 wt.% of glass fibers, fiber fabric by using a bidirectional weaving process, and make the fiber fabric pass through a dipping tank containing the slurry, to obtain single-layer fiber composite layer prepreg with a thickness of 0.12 mm.

S303: Stack three fiber composite layer prepreg layers and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 220 N, and a bending modulus is 28 Gpa.

### Embodiment 5

This embodiment provides a fiber composite plate, which is prepared by using the following method.

S301: Prepare slurry according to the foregoing method.

S302: Form, by using 80 wt.% of PBO fibers and 20 wt.% of glass fibers, fiber fabric by using a bidirectional weaving process, and make the fiber fabric pass through a dipping tank containing the slurry, to obtain single-layer fiber composite layer prepreg with a thickness of 0.12 mm.

S303: Stack three fiber composite layer prepreg layers and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 240 N, and a bending modulus is 26 Gpa.

### Embodiment 6

This embodiment provides a fiber composite plate, which is prepared by using the following method.

S301: Prepare slurry according to the foregoing method.

S302: Form, by using 90 wt.% of PBO fibers and 10 wt.% of glass fibers, fiber fabric by using a bidirectional weaving process, and make the fiber fabric pass through a dipping tank containing the slurry, to obtain single-layer fiber composite layer prepreg with a thickness of 0.12 mm.

S303: Stack three fiber composite layer prepreg layers and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 250 N, and a bending modulus is 25 Gpa.

### Comparative example 1

This embodiment provides a fiber composite plate, which is prepared by using the following method.

S301: Prepare slurry according to the foregoing method.

S302: Form, by using 100 wt.% of glass fibers, fiber fabric by using a bidirectional weaving process, and make the fiber fabric pass through a dipping tank containing the slurry, to obtain single-layer fiber composite layer prepreg with a thickness of 0.12 mm.

S303: Stack three fiber composite layer prepreg layers and perform hot-pressing, to obtain a fiber composite plate with a thickness of 0.45 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 70 N, and a bending modulus is 28 Gpa.

### Comparative example 2

This embodiment provides a fiber composite plate, which is prepared by using the following method.

S301: Prepare slurry according to the foregoing method.

S302: Form, by using 100 wt.% of ceramic fibers, fiber fabric by using a bidirectional weaving process, and make the fiber fabric pass through a dipping tank containing the slurry, to obtain single-layer fiber composite layer prepreg with a thickness of 0.15 mm.

S303: Stack three fiber composite layer prepreg layers and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 60 N, and a bending modulus is 53 Gpa.

### Comparative example 3

This embodiment provides a fiber composite plate, which is prepared by using the following method.

S301: Prepare slurry according to the foregoing method.

S302: Form, by using 100 wt.% of PBO fibers, fiber fabric by using a bidirectional weaving process, and make the fiber fabric pass through a dipping tank containing the slurry, to obtain single-layer fiber composite layer prepreg with a thickness of 0.12 mm.

S303: Stack three fiber composite layer prepreg layers and perform hot-pressing, to obtain a fiber composite plate with a thickness of 0.35 mm, where a temperature for hot-pressing is 150°C, and processing time is 6 min.

Puncture strength of the fiber composite plate is tested according to GB/T10004-2008. It is determined, through testing, that the puncture strength of the fiber composite plate in this embodiment is 260 N, and a bending modulus is 21 Gpa.

**Table 1**

| Sample group | First fiber 2:Second fiber 3 (wt.%) | Thickness of the fiber composite plate (mm) | Puncture strength (N) | Bending modulus (Gpa) |
|---|---|---|---|---|
| Embodiment 1 | 60:40 | 0.35 | 200 | 36 |
| Embodiment 2 | 60:40 | 0.35 | 180 | 29 |
| Embodiment 3 | 60:40 | 0.35 | 190 | 31 |
| Embodiment 4 | 70:30 | 0.35 | 220 | 28 |
| Embodiment 5 | 80:20 | 0.35 | 240 | 26 |
| Embodiment 6 | 90:10 | 0.35 | 250 | 25 |
| Comparative example 1 | / | 0.45 | 70 | 28 |
| Comparative example 2 | / | 0.35 | 60 | 53 |
| Comparative example 3 | / | 0.35 | 260 | 21 |

It can be learned from the data in Table 1 that, in testing of the puncture strength of the fiber composite plate, Embodiment 2 is compared with Embodiment 1. On the premise that the fiber composite plates have the same thickness, through comparison between the fiber composite plate formed by weaving the PBO fiber and the ceramic fiber and the fiber composite plate formed by weaving the PBO fiber and the glass fiber, weaving the PBO fiber and the ceramic fiber can improve a puncture resistance capability of the fiber composite plate to some extent.

Embodiment 3 is compared with Embodiments 1 and 2. On the premise that the fiber composite plates have the same thickness, through comparison between the fiber composite plate including both the PBO fiber and the glass fiber, and the PBO fiber and the ceramic fiber and both the fiber composite plate including only the PBO fiber and the ceramic fiber and the fiber composite plate including only the PBO fiber and the glass fiber, the fiber composite plate in Embodiment 3 has higher puncture strength and bending modulus, indicating that the fiber composite plate made of different fiber composite layers has better comprehensive performance.

Embodiments 2, 4, 5, and 6 are compared. On the premise that the fiber composite plates have the same thickness, as content of the PBO fiber increases, the puncture strength of the fiber composite plate formed by weaving the PBO fiber and the glass fiber is 180 N, 220 N, 240 N, and 250 N respectively, that is, the puncture resistance capability is gradually improved. Refer to Comparative example 3. When the content of the PBO fiber reaches 100%, the puncture strength is the highest.

Embodiments 1 to 6 are compared with Comparative examples 1 and 2. Through comparison between a fiber composite layer formed by two types of fibers and a fiber layer formed by independently using one type of fiber, when the fiber composite layer includes two types of fibers, puncture strength of a fiber composite plate is significantly improved. It should be noted that, although the tensile modulus of the ceramic fiber in Comparative example 2 is large, because the ceramic fiber is brittle, the ceramic fiber is prone to breaking during puncture testing. As a result, the puncture strength of the fiber composite plate is low.

In addition, compared with Comparative example 1, Embodiments 1 to 6 further increase puncture resistance strength while reducing the thickness of the fiber composite plate, indicating that the fiber fabric in this application can increase the puncture strength of the fiber composite plate.

Furthermore, compared with Comparative Example 3, Embodiments 1 to 6 increase the bending strength of the fiber composite plate to some extent due to addition of the ceramic fiber and the glass fiber, indicating that addition of rigid fibers can improve rigidity of the fiber composite plate.

Based on a same technical concept, an embodiment of this application provides a terminal device. The terminal device includes a housing and an electronic component disposed in the housing, and at least a part of the housing is the fiber composite plate in embodiments of this application. The terminal device in this application includes but is not limited to an apparatus like a mobile phone, a computer, an electronic watch, a display, a household appliance, or a vehicle.

In the terminal device in this application, the fiber composite plate may be used as at least a part of the housing. Because puncture strength of the fiber composite plate in this application is greater than 130 N, when the fiber composite plate in this application is used as the housing of the terminal device, the fiber composite plate has high strength and rigidity, so that structural strength for protecting an internal electronic component can be met while a thickness of the housing is reduced. This helps implement lightweight and thinness of the entire device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A fiber composite plate, comprising at least one fiber composite layer, wherein each fiber composite layer comprises fiber fabric and polymer resin, and the polymer resin fills pores of the fiber fabric and encapsulates the fiber fabric;
the fiber fabric comprises a first fiber and a second fiber that are interwoven, a tensile modulus of the first fiber is greater than or equal to 150 Gpa, and a bending modulus of the second fiber is greater than or equal to 35 Gpa; and
puncture strength of the fiber composite plate is greater than 130 N.

2. The fiber composite plate according to claim 1, wherein a percentage by mass of the first fiber in each layer of the fiber fabric is within a range of 1 wt.% to 99 wt.%; and
a percentage by mass of the second fiber in each layer of the fiber fabric is within a range of 1 wt.% to 99 wt.%.

3. The fiber composite plate according to claim 1 or 2, wherein a diameter of the first fiber is 10 µm to 18 µm, and a diameter of the second fiber is within a range of 5 µm to 15 µm.

4. The fiber composite plate according to any one of claims 1 to 3, wherein porosity of the fiber fabric is less than or equal to 5%.

5. The fiber composite plate according to any one of claims 1 to 4, wherein the first fiber comprises a PBO fiber, and the second fiber comprises one of a glass fiber and a ceramic fiber.

6. The fiber composite plate according to any one of claims 1 to 5, wherein a percentage by mass of the polymer resin in each fiber composite layer is 30 wt.% to 50 wt.%.

7. The fiber composite plate according to any one of claims 1 to 6, wherein the polymer resin comprises at least one of epoxy resin, bismaleimide resin, polycarbonate resin, or polyetheretherketone resin.

8. The fiber composite plate according to any one of claims 1 to 7, wherein there are two to five fiber composite layers.

9. The fiber composite plate according to any one of claims 1 to 8, wherein a thickness of the fiber composite plate is less than 0.5 mm.

10. A terminal device, comprising a housing and an electronic component disposed in the housing, wherein at least a part of the housing is the fiber composite plate according to any one of claims 1 to 9.
